# EUROPÄISCHE PATENTSCHRIFT

(11) **EP 1 274 097 B1**
(45) Veröffentlichungstag und Bekanntmachung des Hinweises auf die Patenterteilung: **25.08.2010**
(21) Anmeldenummer: 02012755.1
(22) Anmeldetag: 08.06.2002
(51) Int. Cl.: G06F 21/02

(54) **Überprüfung von in einer Speicheranordnung abgelegten Daten**
Verification of data in a memory device
Vérification de données dans un dispositif de mémoire

(30) Priorität: 02.07.2001 DE 10131574
(43) Veröffentlichungstag der Anmeldung: 08.01.2003
(73) Patentinhaber: ROBERT BOSCH GMBH, 70442 Stuttgart (DE)
(72) Erfinder: Pischke, Juergen, 71287 Weissach (DE); Feilen, Oliver, 85296 Rohrbach (DE); Loechel, Norbert, 71120 Grafenau (DE)

(56) Entgegenhaltungen:
- WO-A-00/75759
- DE-A- 19 723 332

## Beschreibung

Die vorliegende Erfindung betrifft ein Verfahren zum Betreiben eines Mikrorechner-Systems. Bei dem Verfahren wird zumindest ein Teil einer Speicheranordnung des Mikrorechner-Systems auf Manipulation von in der Speicheranordnung abgelegten Daten überprüft. In Abhängigkeit von dem Ergebnis der Überprüfung werden Maßnahmen zur Verhinderung einer Abarbeitung der Daten in dem Mikrorechner-System ausgeführt, falls die Maßnahmen aktiviert sind. Die Maßnahmen werden in Abhängigkeit von dem Inhalt eines Festwertspeichers des Mikrorechner-Systems aktiviert oder deaktiviert.

Die Erfindung betrifft außerdem ein Speicherelement für ein Mikrorechner-System, insbesondere für ein Steuergerät eines Kraftfahrzeugs, auf dem ein Computerprogramm abgespeichert ist. Das Computerprogramm ist auf einem Rechengerät des Mikrorechner-Systems, insbesondere auf einem Mikroprozessor, ablauffähig. Das Speicherelement ist beispielsweise als ein Read-Only-Memory, als ein Random-Access-Memory oder ein Flash-Memory ausgebildet.

Die vorliegende Erfindung betrifft des weiteren ein Computerprogramm, das auf einem Rechengerät, insbesondere auf einem Mikroprozessor, eines Mikrorechner-Systems ablauffähig ist.

Schließlich betrifft die Erfindung auch ein Mikrorechner-System mit einer Speicheranordnung, in der Daten, insbesondere ein Steuerprogramm, Parameter oder Grenzwerte, abgelegt sind. Das Mikrorechner-System umfasst des weiteren ein Rechengerät, insbesondere einen Mikroprozessor, zur Abarbeitung der Daten. Außerdem umfasst das Mikrorechner-System Prüfmittel zur Überprüfung der Daten auf Manipulation, Blockiermittel zur Verhinderung einer Abarbeitung der Daten in Abhängigkeit von dem Ergebnis der Überprüfung und erste Betätigungsmittel zur Überprüfung des Inhalts eines Festwertspeichers des Mikrorechner-Systems und zur Aktivierung oder Deaktivierung der Blockiermittel in Abhängigkeit von dem Inhalt des Festwertspeichers.

### Stand der Technik

Aus dem Stand der Technik ist ein Mikrorechner-System der eingangs genannten Art bekannt, das als ein Kraftfahrzeugsteuergerät ausgebildet ist. Das Steuergerät dient zur Steuerung und/oder Regelung von Funktionen oder Einheiten des Kraftfahrzeugs, beispielsweise einer Brennkraftmaschine, eines Antiblockiersystems (ABS), eines elektronischen Lenksystems (Steer-by-Wire), eines elektronischen Bremssystems (Brake-by-Wire) oder einer Klimatisierungsautomatik. Das Steuergerät weist eine Speicheranordnung auf, die als ein wiederbeschreibbarer Speicher, insbesondere als ein Flash-Speicher, ausgebildet ist. In dem Flash-Speicher sind Daten in Form eines Steuerprogramms oder in Form von Paramtern und Grenzwerten abgelegt.

Aufgrund einer Manipulation des Steuerprogramms kann es zu einem Defekt der gesteuerten oder geregelten Einheit des Kraftfahrzeugs kommen. Deshalb sollte eine Manipulation des Steuerprogramms oder der Daten nach Möglichkeit verhindert werden, zumindest aber sollte die Manipulation im Nachhinein erkennbar sein, damit die Ursache eines Defekts einer gesteuerten oder geregelten Einheit festgestellt werden kann bzw. damit Gewährleistungsansprüche richtig zugeordnet werden können.

Trotz der Gefahr einer Manipulation des Steuerprogramms oder der Daten durch unbefugte Personen ist es nicht sinnvoll, den Zugriff auf die Speicheranordnung des Steuergeräts völlig zu verbieten. Um beispielsweise eine Neuprogrammierung des Steuergeräts vornehmen zu können, muss es einem befugten Benuzerkreis möglich sein, auf die Speicheranordnung zuzugreifen. Es kann nämlich erforderlich sein, von Zeit zu Zeit eine neue Version eines Steuerprogramms oder neue Parameter oder Grenzwerte in dem Steuergerät abzulegen, um beispielsweise Fehler in der Software zu beseitigen oder neuen gesetzlichen Vorgaben Rechnung zu tragen.

Das bekannte Steuergerät verfügt über Prüfmittel zur Überprüfung zumindest eines Teils der in dem Flash-Speicher abgelegten Daten auf Manipulation. Aus dem Stand der Technik sind unterschiedliche Verfahren zur Überprüfung von in einer Speicheranordnung abgelegten Daten auf Manipulation bekannt, die alle im Rahmen der vorliegenden Erfindung Anwendung finden können. Aus der DE 197 23 332 A1 ist es beispielsweise bekannt, über zumindest einen Teil der Speicheranordnung ein Codewort, beispielsweise eine Checksumme, zu bilden und diese mit einem Vergleichscodewort zu vergleichen, das in dem Flash-Speicher gespeichert ist. Falls das Codewort nicht gleich dem Vergleichscodewort ist, wird von einer Manipulation der Daten ausgegangen.

Das bekannte Steuergerät verfügt außerdem über aktivierbare und deaktivierbare Blockiermittel zur Verhinderung einer Abarbeitung des Steuerprogramms oder einer Nutzung der Parameter oder Grenzwerte, falls im Rahmen der Überprüfung eine Manipulation der Daten erkannt wird. Die Abarbeitung der Daten wird nur dann verhindert, wenn die Blockiermittel aktiviert sind. Zur Aktivierung bzw. Deaktivierung der Blockiermittel wird bei dem bekannten Steuergerät der Inhalt eines Festwertspeichers des Steuergeräts überprüft. Der Festwertspeicher ist beispielsweise als ein EEPROM (Electronically Erasable Programmable Read Only Memory) ausgebildet. Das Steuergerät verfügt über erste Betätigungsmittel, die die Blockiermittel in Abhängigkeit von dem Inhalt des Festwertspeichers aktivieren oder deaktivieren. Bei aktivierten Blockiermitteln kann im Falle einer Manipulation der Daten die Abarbeitung der Daten entweder sofort oder zu einem späteren Zeitpunkt, beispielsweise beim nächsten Fahrzyklus, blockiert werden.

Die bekannten Steuergeräte werden standardmäßig mit aktivierten Blockiermitteln als sogenannte Seriengeräte ausgeliefert, so dass die Abarbeitung des Steuerprogramms blockiert wird, falls eine Manipulation des in dem Flash-Speicher abgelegten Steuerprogramms oder der dort abgelegten Parameter oder Grenzwerte festgestellt wird. In bestimmten Situationen, insbesondere während der Entwicklungs- und Erprobungsphase eines Steuergerätes oder eines Steuerprogramms, ist es jedoch erforderlich, ein Blockieren der Abarbeitung der Daten zu deaktivieren, damit verschiedene Daten schnell und einfach in der Speicheranordnung abgelegt werden können. Ein Steuergerät mit deaktivierten Blockiermitteln wird als ein Applikationsgerät bezeichnet.

Nach dem Stand der Technik ist bei Seriengeräten in einem vorgebbaren Speicherbereich des Festwertspeichers mindestens ein Default-Wert abgelegt. Bei Applikationsgeräten wird mindestens einer der Default-Werte durch ein vorgebbares Prüfmuster überschrieben. Die Programmierung dieses Speicherbereichs geschieht im Anschluss an die Fertigung vor der Auslieferung des Steuergeräts. Die ersten Betätigungsmittel zur Überprüfung des Inhalts dieses Speicherbereichs sind in den Daten, d. h. in dem Steuerprogramm realisiert, das in dem Flash-Speicher des Steuergeräts abgelegt ist. Während der Laufzeit des Steuerprogramms wird der Inhalt des Festwertspeichers überprüft. Falls in dem vorgebbaren Speicherbereich des Festwertspeichers nur Default-Werte abgelegt sind, handelt es sich bei dem Steuergerät um ein Seriengerät und die Blockiermittel werden aktiviert. Falls die Prüfmittel also eine Manipulation der in dem Flash-Speicher abgelegten Daten erkennen, wird die Abarbeitung der Daten verhindert. Falls in dem vorgebbaren Speicherbereich des Festwertspeichers mindestens ein vorgebbares Prüfmuster abgelegt ist, handelt es sich bei dem Steuergerät um ein Applikationsgerät und die Blockiermittel werden deaktiviert. Die Abarbeitung der Daten wird also selbst dann nicht verhindert, wenn die Prüfmittel eine Manipulation des Steuerprogramms, der Parameter oder Grenzwerte erkennen.

Der Inhalt des vorgebbaren Speicherbereichs des Festwertspeichers wird auch als eine Hardware-Kennung bezeichnet, da der Inhalt dieses Speicherbereichs nicht ohne weiteres geändert werden kann. Die in dem vorgebbaren Speicherbereich des Festwertspeichers abgelegten Default-Werte und Prüfmuster müssen nämlich auf die Hardware-Umgebung und auf die in dem Flash-Speicher abgelegten Daten abgestimmt sein. Bei dem aus dem Stand der Technik bekannten Steuergerät besteht dennoch die Gefahr, dass unbefugte Dritte ein Blockieren der Abarbeitung manipulierter Daten umgehen, indem der Inhalt des vorgebbaren Speicherbereichs des Festwertspeichers manipuliert wird und ein Seriengerät auf diese Weise als Applikationsgerät gekennzeichnet wird.

Der vorliegenden Erfindung liegt deshalb die Aufgabe zugrunde, den Manipulations- bzw. Tuningschutz von in einer Speicheranordnung eines Mikrorechner-Systems abgelegten Daten zu verbessern, insbesondere die Wirksamkeit und Zuverlässigkeit des Manipulations- bzw. Tuningschutzes zu erhöhen.

Zur Lösung dieser Aufgabe schlägt die Erfindung ausgehend von dem Verfahren der eingangs genannten Art vor, dass in den Daten ein Codewort abgelegt wird, das während des Betriebs des Mikrorechner-System überprüft wird, und die Maßnahmen auch in Abhängigkeit von dem Ergebnis der Überprüfung des in den Daten abgelegten Codeworts aktiviert oder deaktiviert werden.

### Vorteile der Erfindung

Erfindungsgemäß wird also vorgeschlagen, außer der bereits aus dem Stand der Technik bekannten Hardware-Kennung eine Software-Kennung einzuführen, die neben der Hardware-Kennung während der Abarbeitung der in der Speicheranordnung abgelegten Daten überprüft wird. Die Maßnahmen zur Verhinderung einer Abarbeitung der Daten, falls eine Manipulation der in der Speicheranordnung abgelegten Daten erkannt wird, werden in Abhängigkeit des Ergebnisses der Überprüfung der Hardware-Kennung und des Ergebnisses der Software-Kennung aktiviert bzw. deaktiviert. Neben Applikationsgeräten und Seriengeräten wird erfindungsgemäß auch zwischen Applikationsdaten und Seriendaten unterschieden. Die Maßnahmen zur Verhinderung einer Abarbeitung der Daten werden vorzugsweise aktiviert, wenn ein Seriengerät erkannt wurde, wenn Seriendaten erkannt wurden oder wenn ein Seriengerät und Seriendaten erkannt wurden. Die Maßnahmen werden somit nur dann deaktiviert, wenn Applikationsdaten auf einem Applikationsgerät ablaufen.

Im Rahmen der Erstellung der Daten wird bereits festgelegt, ob die Daten für den Applikationsfall oder für den Serienfall bestimmt sein sollen. Je nachdem wird ein vorgebbares Codewort in einem bestimmten Bereich der Daten abgelegt. Das in den Daten abgelegte Codewort kann auf eine besondere Weise ermittelt werden, so dass es von unbefugten Dritten nicht einfach ausgelesen und manipuliert werden kann, um die Daten als Applikationsdaten zu kennzeichnen. Wenn die Daten beispielsweise ein Steuerprogramm umfassen, sind in dem Steuerprogramm auch zweite Betätigungsmittel zur Überprüfung des Codeworts vorgesehen. Das Steuerprogramm überprüft sich also quasi selbst und ermittelt, ob es als ein Steuerprogramm für den Applikationsfall oder für den Serienfall gekennzeichnet ist. Eine Manipulation der Hardware-Kennung alleine reicht bei der vorliegenden Erfindung nun nicht mehr aus, um die Maßnahmen zur Verhinderung einer Abarbeitung der Daten zu deaktivieren.

Gemäß einer vorteilhaften Weiterbildung der vorliegenden Erfindung wird vorgeschlagen, dass die Maßnahmen aktiviert werden, falls in einem vorgebbaren Speicherbereich des Festwertspeichers ein vorgebbares Prüfmuster nicht abgelegt ist. Ein Mikrorechner-System kann als Seriengerät mit aktivierten Maßnahmen zur Verhinderung der Abarbeitung der Daten gekennzeichnet werden, indem in dem vorgebbaren Speicherbereich des Festwertspeichers kein Prüfmuster abgelegt ist. Bei Applikationsgeräten ist dagegen das vorgebbare Prüfmuster in dem Festwertspeicher abgelegt.

Gemäß einer bevorzugten Ausführungsform der vorliegenden Erfindung wird vorgeschalgen, dass die Maßnahmen aktiviert werden, falls ein Codewort in den Daten abgelegt ist. Zur Kennzeichnung von Applikationsdaten sind in einem vorgebbaren Bereich der Daten einer oder mehrere Default-Werte abgelegt. Zur Kennzeichnung von Seriendaten wird mindestens einer dieser Default-Werte durch ein Codewort ersetzt. Das Codewort ist beispielsweise eine Checksumme. Aus Sicherheitsgründen werden in diesem Fall die Maßnahmen zur Verhinderung der Abarbeitung der Daten aktiviert.

Vorteilhafterweise wird auf eine Manipulation der Daten geschlossen, falls das Codewort einem in Äbhängigkeit der Daten mit Hilfe eines vorgebbaren Verschlüsselungsalgorithmus ermittelten Referenz-Codewort nicht entspricht. Durch einen Vergleich des Codeworts mit dem vorgebbaren Referenz-Codewort können die in der Speicheranordnung abgelegten Daten zusätzlich auf Manipulation überprüft werden. Das Referenz-Codewort wird im Vorfeld der Abarbeitung der Daten ermittelt und in der Speicheranordnung oder in einem anderen Speicher des Mikrorechner-Systems abgelegt. Eine fehlende Übereinstimmung des Codeworts mit dem Referenz-Codewort bedeutet, dass entweder die in der Speicheranordnung abgelegten Daten oder das in den Daten abgelegten Codewort manipuliert wurden. Als eine mögliche Maßnahme bei einer erkannten Manipulation kann die Abarbeitung der Daten blockiert werden.

Vorteilhafterweise ist das Codewort abhängig von zumindest einem Teil der in der Speicheranordnung abgelegen Daten. Das Codewort wird vorzugsweise anhand eines asymmetrischen Verschlüsselungsverfahrens gebildet und überprüft.

Gemäß einer anderen vorteilhaften Weiterbildung der vorliegenden Erfindung wird vorgeschlagen, dass zumindest ein Teil der Daten anhand eines Komprimierungsalgorithmus auf einen Fingerprint reduziert wird, der mit Hilfe eines lediglich einem beschränkten Personenkreis zugänglichen privaten Schlüssels zu einer Signatur verschlüsselt wird, und die Signatur als das Codewort in den Daten abgelegt wird. Durch diese Maßnahme ergibt sich eine zusätzliche Sicherheit gegen eine Manipulation der Software-Kennung.

Gemäß einer weiteren bevorzugten Ausführungsform der Erfindung wird vorgeschlagen, dass die Signatur mit Hilfe eines frei zugänglichen öffentlichen Schlüssels zu einem entschlüsselten Fingerprint entschlüsselt wird, aus demselben Teil der Daten und anhand desselben Komprimierungsalgorithmus wie bei der Bildung der Signatur ein Referenz-Fingerprint gebildet wird und der entschlüsselte Fingerprint mit dem Referenz-Fingerprint verglichen wird. Es wird vorzugsweise auf manipulierte Daten geschlossen, falls der entschlüsselte Fingerprint nicht gleich dem Referenz-Fingerprint ist.

Von besonderer Bedeutung ist die Realisierung des erfindungsgemäßen Verfahrens in der Form eines Speicherelements, das für ein Mikrorechner-System, insbesondere für ein Steuergerät eines Kraftfahrzeugs, vorgesehen ist. Dabei ist auf dem Speicherelement ein Computerprogramm abgespeichert, das auf einem Rechengerät des Mikrorechner-Systems, insbesondere auf einem Mikroprozessor, ablauffähig und zur Ausführung des erfindungsgemäßen Verfahrens geeignet ist. In diesem Fall wird also die Erfindung durch ein auf dem Speicherelement abgespeichertes Computerprogramm realisiert, so dass dieses mit dem Computerprogramm versehene Speicherelement in gleicher Weise die Erfindung darstellt wie das Verfahren, zu dessen Ausführung das Computerprogramm geeignet ist. Als Speicherelement kann insbesondere ein elektrisches Speichermedium zur Anwendung kommen, beispielsweise ein Read-Only-Memory, ein Random-Access-Memory oder ein Flash-Memory.

Die Erfindung betrifft auch ein Computerprogramm der eingangs genannten Art, das zur Ausführung des erfindungsgemäßen Verfahrens geeignet ist, wenn es auf dem Rechengerät abläuft. Besonders bevorzugt ist dabei, wenn das Computerprogramm auf einem Speicherelement, insbesondere auf einem Flash-Memory, abgespeichert ist.

Als eine weitere Lösung der Aufgabe der vorliegenden Erfindung wird ausgehend von dem Mikrorechner-System der eingangs genannten Art vorgeschlagen, dass in den Daten ein Codewort abgelegt ist und das Mikrorechner-System zweite Betätigungsmittel zur Überprüfung des Codeworts während der Abarbeitung der Daten und zur Aktivierung oder Deaktivierung der Blockiermittel in Abhängigkeit von dem Codewort aufweist.

Während die ersten Betätigungsmittel zur Überprüfung der Hardware-Kennung vorgesehen sind, dienen die zweiten Betätigungsmittel zur Überprüfung der erfindungsgemäß vorgesehenen Software-Kennung. Wenn eines der beiden Betätigungsmittel oder aber auch beide Betätigungsmittel eine Aktivierung der Blockiermittel anzeigen, werden die Maßnahmen zur Verhinderung der Abarbeitung der Daten aktiviert. Sobald dann eine Manipulation der in der Speicheranordnung abgelegten Daten erkannt wird, wird die Abarbeitung dieser Daten verhindert. Die Abarbeitung der Daten kann entweder sofort oder aber erst zu einem späteren Zeitpunkt, beispielsweise beim nächsten Fahrzyklus, blockiert werden.

### Zeichnungen

Weitere Merkmale, Anwendungsmöglichkeiten und Vorteile der Erfindung ergeben sich aus der nachfolgenden Beschreibung von Ausführungsbeispielen der Erfindung, die in der Zeichnung dargestellt sind. Dabei bilden alle beschriebenen oder dargestellten Merkmale für sich oder in beliebiger Kombination den Gegenstand der Erfindung, unabhängig von ihrer Zusammenfassung in den Patentansprüchen oder deren Rückbeziehung sowie unabhängig von ihrer Formulierung bzw. Darstellung in der Beschreibung bzw. in der Zeichnung. Es zeigen:
- Figur 1: ein erfindungsgemäßes Mikrorechner-System gemäß einer bevorzugten Ausführungsform;
- Figur 2: ein Ablaufdiagramm eines erfindungsgemäßen Verfahrens zum Überprüfen einer Software-Kennung; und
- Figur 3: ein Ablaufdiagramm des gesamten erfindungsgemäßen Verfahrens gemäß einer bevorzugten Ausführungsform.

### Beschreibung der Ausführungsbeispiele

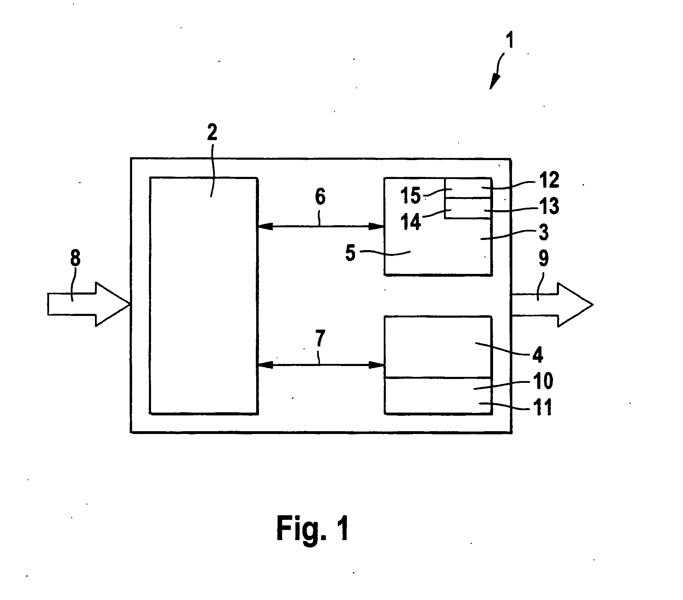

In Figur 1 ist ein erfindungsgemäßes Mikrorechner-System in seiner Gesamtheit mit dem Bezugszeichen 1 bezeichnet. Das Mikrorechner-System 1 ist als ein Steuergerät für ein Kraftfahrzeug ausgebildet. Das Steuergerät dient zur Steuerung und/oder Regelung von Funktionen oder Einheiten in einem Kraftfahrzeug, beispielsweise einer Brennkraftmaschine, eines Antiblockiersystems (ABS), eines elektronischen Lenksystems (Steer-by-Wire) oder eines elektronischen Bremssystems (Brake-by-Wire). Das Mikrorechner-System 1 weist ein Rechengerät 2 auf, das als ein Mikroprozessor ausgebildet ist. Außerdem verfügt das Mikrorechner-System 1 über eine Speicheranordnung 3, die als ein wiederbeschreibbarer Speicher, insbesondere als ein Flash-Speicher, ausgebildet ist. Darüber hinaus umfaßt das Mikrorechner-System 1 einen Festwertspeicher 4, der als ein EEPROM (Electronically Erasable Programmable Read Only Memory) ausgebildet ist.

In der Speicheranordnung 3 sind Daten 5 abgelegt, die von dem Rechengerät 2 zur Realisierung der Steuerungs- oder Regelungsaufgabe des Steuergeräts 1 abgearbeitet werden können. Die Daten 5 sind beispielsweise als ein Steuerprogramm, als Parameter oder als Grenzwerte ausgebildet. Zwischen dem Rechengerät 2 und der Speicheranordnung 3 ist eine bidirektionale Datenübertragungsverbindung 6 vorgesehen, über die zum einen die zu verarbeitenden Daten 5 aus der Speicheranordnung 3 an das Rechengerät 2 und zum anderen in der Speicheranordnung 3 abzulegende Werte, wie beispielsweise die Ergebnisse von Berechnungen, von dem Rechengerät 2 an die Speicheranordnung 3 übertragen werden können. In dem Festwertspeicher 4 sind vertrauliche Daten, wie beispielsweise Informationen über eine Wegfahrsperre eines Kraftfahrzeugs, abgelegt. Diese Angaben können über eine Datenübertragungsverbindung 7 von dem Festwertspeicher 4 an das Rechengerät 2 übertragen werden.

Dem Mikrorechner-System 1 werden Eingangssignale 8 zugeführt, die dem Mikrorechner-System 1 Informationen über den Zustand von zu steuernden bzw. zu regelnden Funktionen oder Einheiten liefern. Die Eingangssignale 8 werden beispielsweise von Sensoren oder Messwertaufnehmern (nicht dargestellt) erfasst. Im Rahmen der Abarbeitung des in der Speicheranordnung 3 ebenfalls abgelegten Steuerprogramms und unter Verarbeitung der Eingangssignale 8 und der in der Speicheranordnung 3 abgelegten Parameter oder Grenzwerte erzeugt das Mikrorechner-System 1 Ausgangssignale 9, die an die zu steuernden bzw. zu regelnden Funktionen oder Einheiten geleitet werden. Über die Ausgangssignale 9 kann der Zustand von zu steuernden oder zu regelnden Funktionen oder Einheiten beeinflusst werden.

In dem Mikrorechner-System 1 sind Prüfmittel zur Überprüfung zumindest eines Teils der in der Speicheranordnung 3 abgelegten Daten 5 auf Manipulation vorgesehen. Falls eine Manipulation der Daten 5 erkannt wird, kann die Abarbeitung der Daten 5 in dem Rechengerät 2 durch Blockiermittel verhindert werden. Die Abarbeitung der Daten 5 kann unmittelbar nach der Detektion einer Manipulation der Daten 5 oder aber erst zu einem vorgebbaren späteren Zeitpunkt, beispielsweise beim nächsten Fahrzyklus, blockiert werden. Die Blockiermittel können aktiviert und deaktiviert werden. Bei einem als Applikationsgerät gekennzeichneten Mikrorechner-System 1 sind die Blockiermittel deaktiviert. Applikationsgeräte werden insbesondere in der Entwicklungs- und Erprobungsphase eines Kraftfahrzeugsteuergeräts 1 oder des in der Speicheranordnung 3 abgelegten Steuerprogramms 5 eingesetzt. Bei einem als Seriengerät gekennzeichneten Mikrorechner-System 1 sind die Blockiermittel dagegen aktiviert, so dass bei einer Detektion von manipulierten Daten 5 die Abarbeitung der Daten 5 blockiert wird. Die aktivierten Blockiermittel in Seriengeräten sollen verhindern, dass das Mikrorechner-System 1 mit manipulierten Daten 5 betrieben wird oder zumindest einen Nachweis einer Manipulation der Daten 5 ermöglichen.

Zur Kennzeichnung eines Mikrorechner-Systems 1 als Applikationsgerät ist in einem vorgebbaren Speicherbereich 10 des Festwertspeichers 4 ein vorgebbares Prüfmuster 11 abgelegt. Während der Abarbeitung der Daten 5 in dem Rechengerät 2, d. h. während der Laufzeit des Steuerprogramms wird der Inhalt des Speicherbereichs 10 des Festwertspeichers 4 überprüft. Falls das vorgebbare Prüfmuster 11 in dem Speicherbereich 10 abgelegt ist, wird davon ausgegangen, dass das Mikrorechner-System 1 ein Applikationssgerät ist und die Blockiermittel werden deaktiviert. Anderenfalls wird davon ausgegangen, dass das Mikrorechner-System 1 ein Seriengerät ist und die Blockiermittel werden aktiviert. Die Überprüfung des Inhalts des Speicherbereichs 10 des Festwertspeichers 4 wird durch erste Betätigungsmittel ausgeführt. Die Prüfmittel, die Blockiermittel und die ersten Betätigungsmittel zur Überprüfung des Speicherbereichs 10 des Festwertspeichers 4 sind Teil der Daten 5 und vorzugsweise in dem Steuerprogramm realisiert, das auf dem Rechengerät 2 ablauffähig ist.

Zur Verbesserung des Schutzes vor Manipulation der in der Speicheranordnung 3 abgelegten Daten 5 wird gemäß der vorliegenden Erfindung vorgeschlagen, neben der sogenannten Hardware-Kennung (Prüfmuster 11) eine Software-Kennung vorzusehen und die Blockiermittel in Abhängigkeit der Hardware-Kennung und der Software-Kennung zu aktivieren bzw. zu deaktivieren. Als Software-Kennung wird der Inhalt von vorgebbaren Bereichen 12 und 13 der Daten 5 bezeichnet. Durch die Software-Kennung können die Daten 5 als Applikationsdaten oder als Seriendaten gekennzeichnet werden. Bei Applikationsdaten sind in den Bereichen 12, 13 der Daten 5 Default-Werte 14 abgelegt. Die Default-Werte 14 sind von außen als Teil des in der Speicheranordnung 3 abgelegten Steuerprogramms 5 ohne Kenntnis der Speicheradressen der Bereiche 12, 13 nicht von dem übrigen Steuerprogramm 5 zu unterscheiden. Bei Seriendaten ist mindestens einer der Default-Werte 14 durch ein Codewort 15 ersetzt. Die Überprüfung der Software-Kennung erfolgt durch zweite Betätigungsmittel, die ebenfalls in den Daten 5, bspw. in dem Steuerprogramm, realisiert sind.

Gemäß der vorliegenden Erfindung werden die Blockiermittel zur Verhinderung der Abarbeitung der Daten 5 aktiviert, falls in dem vorgebbaren Speicherbereich 10 des Festwertspeichers 4 das Prüfmuster 11 nicht abgelegt ist, falls das Codewort 15 in mindestens einem der Bereiche 12, 13 der Daten 5 abgelegt ist oder falls beide Bedinungen zutreffen. In diesen Fällen wird also die Abarbeitung der Daten 5 blockiert, sofern eine Manipulation der Daten 5 erkannt wurde. Nur falls keine der Bedingungen zutrifft, werden die Blockiermittel deaktiviert, so dass während der Entwicklungs- oder Erprobungsphase des Mikrorechner-Systems 1 oder der Daten 5 in der Speicheranordnung 3 beliebige Daten 5 abgelegt werden können, ohne dass eine Blockierung der Abarbeitung der Daten 5 eintritt. Anders ausgedrückt, werden die Blockiermittel nur dann deaktiviert, wenn Applikationsdaten auf einem Applikationsgerät ablaufen.

Ein weiterer Aspekt der vorliegenden Erfindung besteht darin, dass zur Detektion einer Manipulation der Daten 5 das in den Bereichen 12, 13 der Daten 5 abgelegte Codewort 15 herangezogen wird. Dazu wird das Codewort 15 als Referenz-Codewort vor der Laufzeit der Daten 5 in Abhängigkeit von nicht manipulierten Daten 5 nach einem vorgebbaren Verschlüsselungsalgorithmus ermittelt. Während der Laufzeit der Daten 5 wird in Abhängigkeit von den in der Speicheranordnung 3 abgelegten Daten 5 oder eines Teils davon ein weiteres Codewort ermittelt, das mit dem Referenz-Codwort verglichen wird. Falls das ermittelte Codewort gleich dem Referenz-Codewort ist, sind die Daten 5 in Ordnung. Anderenfalls wird auf manipulierte Daten 5 geschlossen.

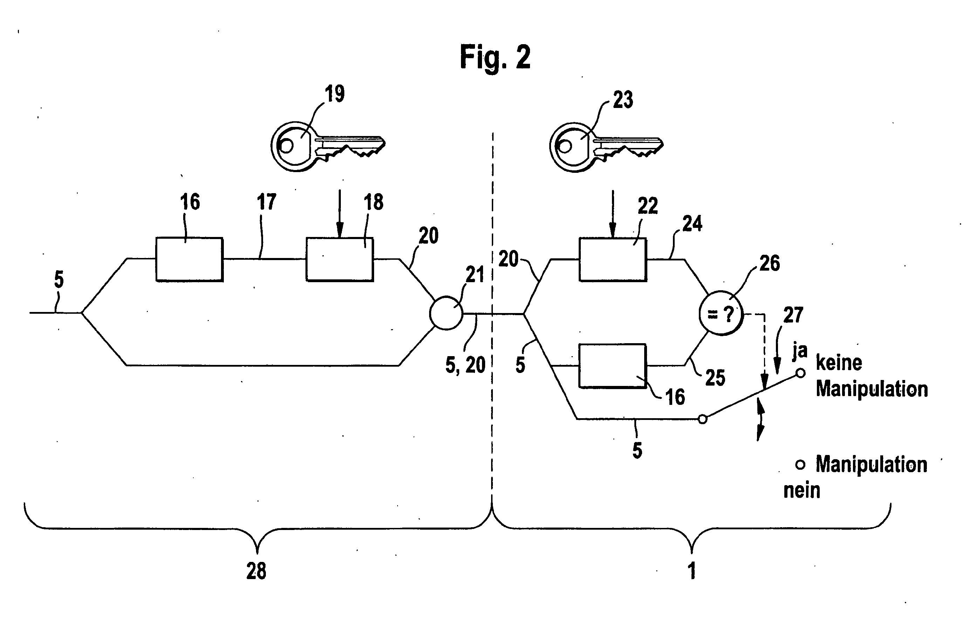

In Figur 2 ist ein Ablaufdiagramm des Teils des erfindungsgemäßen Verfahrens dargestellt, das die Software-Kennung und die Überprüfung der Daten 5 auf Manipulation betrifft. Die in der Speicheranordnung 3 des Mikrorechner-Systems 1 abzulegenden Daten 5 werden außerhalb des Mikrorechner-Systems 1, beispielsweise in einem Programmiergerät oder beim Ersteller 28 der Daten 5, zumindest teilweise anhand eines Komprimierungsalgorithmus 16 auf einen Fingerprint 17 reduziert. Der Fingerprint 17 wird anhand eines Verschlüsselungsalgorithmus 18 mit Hilfe eines lediglich einem beschränkten Personenkreis zugänglichen privaten Schlüssels 19 verschlüsselt. Der verschlüsselte Fingerprint wird als Signatur 20 bezeichnet. In einem Funktionsblock 21 wird die Signatur 20 an die Daten 5 angehängt, d. h. als Codewort in mindestens einem der Bereiche 12, 13 der Daten 5 abgelegt. Danach werden die Daten 5 mit der Signatur 20 bspw. über ein Programmiergerät an das Mikrorechner-System 1 übertragen.

In dem Mikrorechner-System 1 wird die Signatur 20 dann anhand eines Entschlüsselungsalgorithmus 22 und mit Hilfe eines frei zugänglichen öffentlichen Schlüssels 23 zu einem entschlüsselten Fingerprint 24 entschlüsselt. Aus dem Teil der Daten 5, die für die Bildung der Signatur 20 außerhalb des Mikrorechner-Systems 1 herangezgogen wurden, wird anhand desselben Komprimierungsalgorithmus 16 ein Referenz-Fingerprint 25 erzeugt. In einem Funktionsblock 26 wird überprüft, ob der entschlüsselte Fingerprint 24 gleich dem Referenz-Fingerprint 25 ist.

In Abhängigkeit von dem Ergebnis der in dem Funktionsblock 26 ausgeführten Abfrage wird ein Schaltelement 27 angesteuert, durch das die Daten 5 als manipuliert oder nicht manipuliert gekennzeichnet werden. Falls der entschlüsselte Fingerprint 24 gleich dem Referenz-Fingerprint 25 ist, war die Überprüfung der Signatur 20 erfolgreich und die Daten 5 sind nicht manipuliert, bzw. es wurde keine Manipulation der Daten 5 erkannt. Anderenfalls werden die Daten 5 als manipuliert gekennzeichnet. In diesem Fall wird bspw. die Abarbeitung der Daten 5 blockiert.

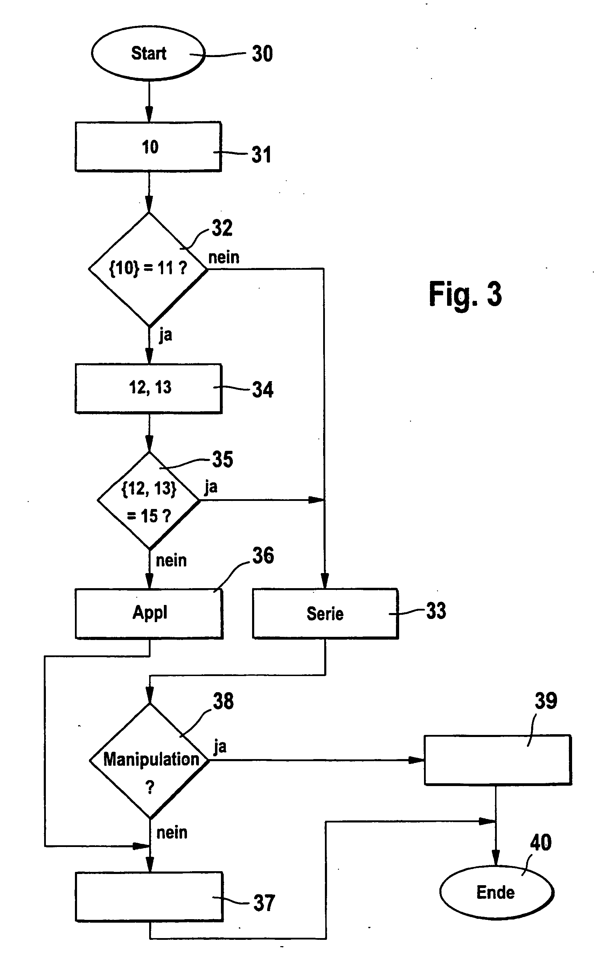

In Figur 3 ist ein Ablaufdiagramm des gesamten erfindungsgemäßen Verfahrens dargestellt. Das Verfahren beginnt in einem Funktionsblock 30. Es wird im Rahmen der Abarbeitung der Daten 5, beispielsweise zur Laufzeit eines Steuerprogramms, ausgeführt. Zunächst wird die Hardware-Kennung überprüft. In einem Funktionsblock 31 wird der Inhalt des Speicherbereichs 10 des Festwertspeichers 4 eingelesen. In einem Abfrageblock 32 wird dann überprüft, ob der Inhalt des Speicherbereichs 10 gleich dem Prüfmuster 11 ist. Falls nein (Serienfall), wird zu einem Funktionsblock 33 verzweigt, in dem die Maßnahmen zur Verhinderung einer Abarbeitung der Daten 5 aktiviert werden.

Falls der Inhalt des Speicherbereichs 10 gleich dem Prüfmuster 11 ist, wird die Software-Kennung überprüft. Es wird zu einem Funktionsblock 34 verzweigt, in dem der Inhalt der Bereiche 12, 13 der Daten 5 eingelesen wird. Anschließend wird in einem Abfrageblock 35 überprüft, ob in den Bereichen 12, 13 der Daten 5 das Codewort 15 abgelegt ist. Falls ja (Serienfall), wird zu dem Funktionsblock 33 verzweigt, in dem die Maßnahmen zur Verhinderung einer Abarbeitung der Daten 5 aktiviert werden. Falls in den Bereichen 12, 13 der Daten 5 kein Codewort 15 abgelegt ist, d. h. es sind nur Default-Werte 14 in den Bereichen 12, 13 abgelegt, wird zu einem Funktionsblock 36 verzweigt, in dem die Maßnahmen zur Verhinderung der Abarbeitung der Daten 5 deaktiviert werden (Applikationsfall).

Im Applikationsfall können die Daten 5 ganz normal abgearbeitet werden. Deshalb wird von dem Funktionsblock 36 zu einem Funktionsblock 37 verzweigt, in dem die Daten 5 abgearbeitet werden, d. h. das Steuerprogramm ganz normal ausgeführt wird. Im Serienfall wird dagegen überprüft, ob die Daten 5 manipuliert sind. Deshalb wird von dem Funktionsblock 33 zu einem Abfrageblock 38 verzweigt, in dem die Daten 5 auf Manipulation geprüft werden. Zur Überprüfung einer Manipulation der Daten 5 sind aus dem Stand der Technik eine Vielzahl unterschiedlicher Verfahren bekannt, die im Rahmen der vorliegenden Erfindung eingesetzt werden können.

Die Abfrageblöcke 35 und 38 können auch zu einem gemeinsamen Abfrageblock zusammengefaßt werden, in dem dann das in Figur 2 dargestellte Verfahren ausgeführt wird. Wenn in mindestens einem der Bereiche 12, 13 das Codewort 15 abgelegt ist, bedeutet dies, dass der Serienfall vorliegt. Entspricht das Codewort 15 darüber hinaus nicht einem Referenz-Codewort, liegt eine Manipulation der Daten 5 vor.

Falls in dem Abfrageblock 38 eine Manipulation der Daten 5 erkannt wird, wird zu einem Funktionsblock 39 verzweigt, in dem die Maßnahmen zu Verhinderung der Abarbeitung der Daten 5 aktiviert werden. Danach wird zu einem Funktionsblock 40 verzweigt, und das Verfahren ist beendet. Falls in dem Abfrageblock 38 keine Manipulation der Daten 5 erkannt wird, wird zu dem Funktinosblock 37 verzweigt und die Daten 5 werden in dem Funktionsblock 37 ganz normal abgearbeitet.

## Patentansprüche

1. Verfahren zum Betreiben eines Mikrorechner-Systems (1), bei dem zumindest ein Teil einer Speicheranordnung (3) des Mikrorechner-Systems (1) auf Manipulation von in der Speicheranordnung (3) abgelegten Daten (5) überprüft wird und in Abhängigkeit von dem Ergebnis der Überprüfung Maßnahmen zur Verhinderung einer Abarbeitung der Daten (5) in dem Mikrorechner-System (1) ausgeführt werden, falls die Maßnahmen aktiviert sind, wobei die Maßnahmen in Abhängigkeit von dem Inhalt eines Festwertspeichers (4) des Mikrorechner-Systems (1) aktiviert oder deaktiviert werden, **dadurch gekennzeichnet, dass** das Mikrorechner-System in Abhängigkeit von dem Inhalt eines Festwertspeichers (4) als Seriengerät oder Applikationsgerät gekennzeichnet wird, dass in den Daten (5) ein Codewort (15) abgelegt wird, das während des Betriebs des Mikrorechner-Systems (1) überprüft wird, wobei abhängig von dem Codewort die Daten als Applikationsdaten oder als Seriendaten erkannt werden und die Maßnahmen auch in Abhängigkeit von dem Ergebnis der Überprüfung des in den Daten (5) abgelegten Codeworts (15) aktiviert oder deaktiviert werden und dass die Maßnahmen nur bei einen Applikationsgerät mit Applikationsdaten deaktiviert werden.

2. Verfahren nach Anspruch 1, **dadurch gekennzeichnet, dass** die Maßnahmen aktiviert werden, falls in einem vorgebbaren Speicherbereich (10) des Festwertspeichers (4) ein vorgebbares Prüfmuster (11) nicht abgelegt ist.

3. Verfahren nach Anspruch 1 oder 2, **dadurch gekennzeichnet, dass** die Maßnahmen aktiviert werden, wenn in einem vorgebbaren Speicherbereich (10) des Festwertspeichers (4) ein vorgebbares Prüfmuster (11) abgelegt ist und ein Codewort (15) in den Daten (5) abgelegt ist.

4. Verfahren nach Anspruch 3, **dadurch gekennzeichnet, dass** auf eine Manipulation der Daten (5) geschlossen wird, falls das Codewort (15) einem in Äbhängigkeit von den Daten (5) mit Hilfe eines vorgebbaren Verschlüsselungsalgorithmus ermittelten Referenz-Codewort nicht entspricht.

5. Verfahren nach einem der Ansprüche 1 bis 4, **dadurch gekennzeichnet, dass** das Codewort (15) abhängig ist von zumindest einem Teil der in der Speicheranordnung (3) abgelegten Daten (5).

6. Verfahren nach Anspruch 5, **dadurch gekennzeichnet, dass** das Codewort (15) anhand eines asymmetrischen Verschlüsselungsverfahrens gebildet und überprüft wird.

7. Verfahren nach Anspruch 6, **dadurch gekennzeichnet, dass** zumindest ein Teil der Daten (5) anhand eines Komprimierungsalgorithmus (16) auf einen Fingerprint (17) reduziert wird, der mit Hilfe eines lediglich einem beschränkten Personkreis zugänglichen privaten Schlüssels (19) zu einer Signatur (20) verschlüsselt wird, und die Signatur (20) als das Codewort (15) in den Daten (5) abgelegt wird.

8. Verfahren nach Anspruch 7, **dadurch gekennzeichnet, dass** die Signatur (20) mit Hilfe eines frei zugänglichen öffentlichen Schlüssels (23) zu einem entschlüsselten Fingerprint (24) entschlüsselt wird, aus demselben Teil der Daten (5) und anhand desselben Komprimierungsalgorithmus (16) wie bei der Bildung der Signatur (20) ein Referenz-Fingerprint (25) gebildet wird und der entschlüsselte Fingerprint (24) mit dem Referenz-Fingerprint (25) verglichen wird.

9. Verfahren nach Anspruch 8, **dadurch gekennzeichnet, dass** auf eine Manipulation der Daten (5) geschlossen wird, falls der entschlüsselte Fingerprint (24) nicht gleich dem Referenz-Fingerprint (25) ist.

10. Speicherelement, insbesondere Read-Only-Memory, Random-Access-Memory oder Flash-Memory, für ein Mikrorechner-System (1), insbesondere für ein Steuergerät eines Kraftfahrzeugs, auf dem ein Computerprogramm (5) abgespeichert ist, das auf einem Rechengerät (2) des Mikrorechner-Systems, insbesondere auf einem Mikroprozessor, abblauffähig und zur Ausführung eines Verfahrens nach einem der Ansprüche 1 bis 9 geeignet ist.

11. Computerprogramm, das auf einem Rechengerät (2), insbesondere auf einem Mikroprozessor, eines Mikrorechner-Sytsems (1) ablauffähig ist, **dadurch gekennzeichnet, dass** das Computerprogramm zur Ausführung eines Verfahrens nach einem der Ansprüche 1 bis 9 geeignet ist, wenn es auf dem Rechengerät (2) abläuft.

12. Computerprogramm nach Anspruch 11, **dadurch gekennzeichnet, dass** das Computerprogramm auf einem Speicherelement, insbesondere auf einem Flash-Memory, abgespeichert ist.

13. Mikrorechner-System (1) mit einer Speicheranordnung (3), in der Daten (5), insbesondere ein Steuerprogramm, Parameter oder Grenzwerte, abgelegt sind, mit einem Rechengerät (2), insbesondere einem Mikroprozessor, zur Abarbeitung der Daten (5), mit Prüfmitteln zur Überprüfung zumindest eines Teils der Daten (5) auf Manipulation, mit Blockiermitteln zur Verhinderung einer Abarbeitung der Daten (5) in Abhängigkeit von dem Ergebnis der Überprüfung und mit ersten Betätigungsmitteln zur Überprüfung des Inhalts eines Festwertspeichers (4) des Mikrorechner-Systems (1) und zur Aktivierung oder Deaktivierung der Blockiermittel in Abhängigkeit von dem Inhalt des Festwertspeichers (4), **dadurch gekennzeichnet, dass** die ersten Betätigungsmitteln als Ergebnis der Überprüfung des Inhalts eines Festwertspeichers (4) des Mikrorechner-Systems (1) als Seriengerät oder Applikationsgerät gekennzeichnet, dass in den Daten (5) ein Codewort (15) abgelegt ist und das Mikrorechner-System (1) zweite Betätigungsmittel zur Überprüfung des Codeworts (15) während der Abarbeitung der Daten (5) und zur Aktivierung oder Deaktivierung der Blockiermittel in Abhängigkeit von dem Codewort (15) aufweist, wobei abhängig von dem Codewort die Daten als Applikationsdaten oder als Seriendaten erkannt werden und dass weitere Mittel vorgesehen sind, die bei einen Applikationsgerät mit Applikationsdaten die Maßnahmen deaktivieren.

## Claims

1. Method for operating a microcomputer system (1), in which at least one portion of a memory arrangement (3) in the microcomputer system (1) is checked for manipulation of data (5) stored in the memory arrangement (3), and the result of the check is taken as a basis for performing measures to prevent the data (5) from being processed in the microcomputer system (1) if the measures have been activated, said measures being activated or deactivated on the basis of the content of the read only memory (4) in the microcomputer system (1), **characterized in that** the microcomputer system is denoted as a serial appliance or application appliance on the basis of the content of a read only memory (4), **in that** the data (5) are used to store a codeword (15) which is checked during the operation of the microcomputer system (1), wherein the codeword is taken as a basis for recognizing the data as application data or as serial data and the measures are also activated or deactivated on the basis of the result of the check on the codeword (15) stored in the data (5), and **in that** the measures are deactivated only for an application appliance with application data.

2. Method according to Claim 1, **characterized in that** the measures are activated if a prescribable memory area (10) of the read only memory (4) does not store a prescribable check pattern (11).

3. Method according to Claim 1 or 2, **characterized in that** the measures are activated if a prescribable memory area (10) of the read only memory (4) does store a prescribable check pattern (11) and there is a codeword (15) stored in the data (5).

4. Method according to Claim 3, **characterized in that** manipulation of the data (5) is inferred if the codeword (15) does not correspond to a reference codeword ascertained on the basis of the data (5) using a prescribable encryption algorithm.

5. Method according to one of Claims 1 to 4, **characterized in that** the codeword (15) is dependent on at least one portion of the data (5) stored in the memory arrangement (3).

6. Method according to Claim 5, **characterized in that** the codeword (15) is formed and checked using an asymmetric encryption method.

7. Method according to Claim 6, **characterized in that** at least one portion of the data (5) is reduced to a fingerprint (17) using a compression algorithm (16), said fingerprint being encrypted to produce a signature (20) using a private key (19) which is accessible only to a limited group of people, and the signature (20) is stored in the data (5) as the codeword (15).

8. Method according to Claim 7, **characterized in that** the signature (20) is decrypted to produce a decrypted fingerprint (24) using a freely accessible public key (23), a reference fingerprint (25) is formed from the same portion of the data (5) and using the same compression algorithm (16) as for the formation of the signature (20), and the decrypted fingerprint (24) is compared with the reference fingerprint (25).

9. Method according to Claim 8, **characterized in that** manipulation of the data (5) is inferred if the decrypted fingerprint (24) is not the same as the reference fingerprint (25).

10. Memory element, particularly a read only memory, random access memory or flash memory, for a microcomputer system (1), particularly for a controller in a motor vehicle, on which a computer program (5) is stored which can be executed on an arithmetic unit (2) in the microcomputer system, particularly on a microprocessor, and is suitable for performing a method according to one of Claims 1 to 9.

11. Computer program which can be executed on an arithmetic unit (2), particularly on a microprocessor, in a microcomputer system (1), **characterized in that** the computer program is suitable for performing a method according to one of Claims 1 to 9 when it is executed on the arithmetic unit (2).

12. Computer program according to Claim 11, **characterized in that** the computer program is stored on a memory element, particularly on a flash memory.

13. Microcomputer system (1) having a memory arrangement (3) which stores data (5), particularly a control program, parameters or limit values, having an arithmetic unit (2), particularly a microprocessor, for processing the data (5), having checking means for checking at least one portion of the data (5) for manipulation, having blocking means for preventing processing of the data (5) on the basis of the result of the check, and having first operating means for checking the content of a read only memory (4) in the microcomputer system (1) and for activating or deactivating the blocking means on the basis of the content of the read only memory (4), **characterized in that** the first operating means is denoted as a serial appliance or an application appliance as the result of the check on the content of a read only memory (4) in the microcomputer system (1), **in that** the data (5) store a codeword (15) and the microcomputer system (1) has second operating means for checking the codeword (15) during the processing of the data (5) and for activating or deactivating the blocking means on the basis of the codeword (15), wherein the codeword is taken as the basis for recognizing the data as application data or as serial data, and **in that** further means are provided which deactivate the measures for an application appliance with application data.

## Revendications

1. Procédé de gestion d'un système (1) à microcalculateur dans lequel
on vérifie sur au moins une partie de l'ensemble de mémoire (3) du système (1) à microcalculateur si des manipulations ont été effectuées sur des données (5) conservées dans un ensemble de mémoire (3),
des dispositions étant exécutées selon le résultat de la vérification pour empêcher que les données (5) soient traitées dans le système (1) à microcalculateur au cas où les dispositions sont activées,
les dispositions étant activées ou désactivées selon le contenu d'une mémoire (4) à valeurs fixes du système (1) à microcalculateur,
**caractérisé en ce que**
le système à microcalculateur est **caractérisé** comme appareil série ou appareil d'application en fonction du contenu de la mémoire (4) à valeurs fixes,
**en ce qu'**un mot de code (15) est placé dans les données (5) et est vérifié au cours du fonctionnement du système (1) à microcalculateur,
**en ce que** les données sont reconnues comme données d'application ou données série en fonction du mot de code,
**en ce que** les dispositions étant activées ou désactivées selon le résultat de la vérification du mot de code (15) placé dans les données (5) et
**en ce que** les dispositions ne sont désactivées que dans le cas d'un appareil d'application présentant des données d'application.

2. Procédé selon la revendication 1, **caractérisé en ce que** les dispositions sont activées au cas où un motif de vérification (11) prédéterminé n'est pas présent dans une partie prédéterminée (10) de la mémoire (4) à valeurs fixes.

3. Procédé selon les revendications 1 ou 2, **caractérisé en ce que** les dispositions sont activées si un motif de vérification prédéterminé (11) est conservé dans une partie prédéterminée (10) de la mémoire (4) à valeurs fixes et si un mot de code (15) a été placé dans les données (5).

4. Procédé selon la revendication 3, **caractérisé en ce qu'**il conclut que les données (5) ont été manipulées au cas où le mot de code (15) ne correspond pas à un mot de code de référence déterminé en fonction des données (5) à l'aide d'un algorithme de cryptage prédéterminé.

5. Procédé selon l'une des revendications 1 à 4, **caractérisé en ce que** le mot de code (15) dépend d'au moins une partie des données (5) conservées dans l'ensemble de mémoire (3).

6. Procédé selon la revendication 5, **caractérisé en ce que** le mot de code (15) est formé et vérifié à l'aide d'un procédé de cryptage asymétrique.

7. Procédé selon la revendication 6, **caractérisé en ce qu'**à l'aide d'un algorithme de compression (16), au moins une partie des données (5) est réduite à une empreinte digitale (17) qui est cryptée en une signature (20) à l'aide d'une clé privée (19) accessible uniquement à un ensemble réduit de personnes, la signature (20) étant placée dans les données (5) en tant que mot de code (15).

8. Procédé selon la revendication 7, **caractérisé en ce que** la signature (20) est décryptée en une empreinte digitale (24) décryptée à l'aide d'une clé publique (23) à accès libre, **en ce qu'**une empreinte digitale de référence (25) est formée à partir de la même partie des données (5) et à l'aide du même algorithme de compression (16) que ceux utilisés pour la formation de la signature (20) et **en ce que** l'empreinte digitale décryptée (24) est comparée à l'empreinte digitale de référence (25).

9. Procédé selon la revendication (8), **caractérisé en ce qu'**il conclut que les données (5) ont été manipulées au cas où l'empreinte digitale décryptée (24) n'est pas identique à l'empreinte digitale de référence (25).

10. Elément de mémoire, en particulier mémoire morte, mémoire à accès aléatoire ou mémoire dite flash pour un système (1) à microcalculateur, en particulier pour un appareil de commande d'un véhicule automobile, sur lequel un programme informatique (5) est conservé en mémoire et peut être exécuté sur un appareil de calcul (2) du système à microcalculateur et en particulier sur un microprocesseur, et convenant pour exécuter un procédé selon l'une des revendications 1 à 9.

11. Programme informatique apte à être exécuté sur un appareil de calcul (2) et en particulier sur un microprocesseur d'un système (1) à microcalculateur, **caractérisé en ce que** le programme informatique convient pour exécuter un procédé selon l'une des revendications 1 à 9 lorsqu'il est exécuté sur l'appareil de calcul (2).

12. Programme informatique selon la revendication 11, **caractérisé en ce que** le programme informatique est conservé en mémoire sur un élément de mémoire et en particulier sur une mémoire dite flash.

13. Système (1) à microcalculateur présentant un ensemble de mémoire (3) dans lequel des données (5) et en particulier un programme de commande, des paramètres ou des valeurs limites sont conservées,
un appareil de calcul (2), en particulier un microprocesseur, qui traite les données (5),
des moyens de vérification qui vérifient si au moins une partie des données (5) a été manipulée,
des moyens de blocage qui empêchent le traitement des données (5) en fonction du résultat de la vérification et
des premiers moyens d'actionnement qui vérifient le contenu d'une mémoire (4) à valeurs fixes du système (1) à microcalculateur et qui activent ou désactivent les moyens de blocage en fonction du contenu de la mémoire (4) à valeurs fixes,
**caractérisé en ce que**
en résultat de la vérification du contenu d'une mémoire (4) à valeurs fixes du système (1) à microcalculateur, les premiers moyens d'actionnement sont **caractérisés** comme appareil série ou appareil d'application,
**en ce qu'**un mot de code (15) est placé dans les données (5),
**en ce que** le système (1) à microcalculateur présente des deuxièmes moyens d'actionnement qui vérifient le mot de code (15) pendant le traitement des données (5) et qui activent ou désactivent les moyens de blocage en fonction du mot de code (15),
**en ce que** les données sont reconnues comme données d'application ou données série en fonction du mot de code et
**en ce que** d'autres moyens sont prévus pour désactiver les dispositions dans le cas d'un appareil d'application présentant des données d'application.
